# EUROPEAN PATENT SPECIFICATION

(11) **EP 2 259 074 B1**
(45) Date of publication and mention of the grant of the patent: **05.03.2014**
(21) Application number: 10005667.0
(22) Date of filing: 31.05.2010
(51) Int. Cl.: G01P 3/487

(54) **Magnetic speed sensor with cost effective and fast fabrication**
Magnetischer Geschwindigkeitssensor mit kosteneffizienter und schneller Herstellung
Capteur de vitesse magnétique avec fabrication rapide et rentable

(30) Priority: 01.06.2009 US 182783 P
(43) Date of publication of application: 08.12.2010
(73) Proprietor: Methode Electronics, Inc., Chicago, IL 60706 (US)
(72) Inventor: Lee, Seong-Jae, Mount Prospect, Illinois 60056 (US)
(74) Representative: Prinz & Partner

(56) References cited:
- EP-A2- 1 734 370
- US-A- 6 145 387
- US-A1- 2005 061 088

## Description

### CROSS REFERENCE TO RELATED APPLICATIONS

This application is related to and claims priority to U.S. Provisional Appl. 61/182,783, filed June 1, 2009, the content of which is incorporated herein.

### BACKGROUND OF THE INVENTION

### Field of the Invention

This invention is directed to devices for measuring the speed of a rotating shaft using a magnetic speed sensor.

### Description of the Related Art

Speed sensors for rotating shafts are well known in the art. Historically, such devices required some sort of well-defined geometrical structure around a portion of the shaft, such as teeth or grooves, to produce detectable signals representing a change in a magnetic flux. For example, in U.S. 3,769,533, which discloses an adaptive braking wheel speed sensor mounted near a vehicle differential, the disclosed device uses a toothed ring attached to the rear wheel axle. The teeth are circumferentially spaced on the outside of the ring. An electro-magnetic pick-up device having a U-shaped core member made of magnetic iron extends close to the teeth so the ends of the core member sense when one of the teeth is near the ends (or when one of the intermediate spaces between the teeth is near). As the rear wheel axle turns, so does the ring and its teeth, which generates a pulsed electrical output in the core member, the frequency of which is proportional to the speed of the rotation of the axle.

In U.S. 5,223,760, which also discloses a wheel speed sensor for a drive axle, the disclosed device involves a rotor and circular stator element, each having teeth defining slots formed on the inner face of a the stator element. An axially-poled annular magnet provides a magnetic flux that is sensed with a magnetic flux sensor. The magnetic flux sensor may be a simple multi-turn winding having an axis coincident with the axis of the sensor. The rotor is driven by a shaft and positioned co-axially and nested with the stator elements. The teeth and slots of the elements cooperatively create a time- and position-varying magnetic flux that increases and decreases in the magnetic circuit, indicating the angular velocity of the axle.

These spaced gear teeth in the above patents are magnetized from an external magnetic field source such as those provided by permanent magnets or electromagnets. When magnetized, the gear teeth rotate with the shaft to which they are attached, and produce a sinusoidal-shaped electrical output (voltage) signal which can be processed. A Hall sensor, fluxgate sensor, or the like, is mounted proximate to the gear teeth to receive the fluctuating magnetic field. Though useful, such devices are known to be difficult and expensive to manufacture, as discussed in, for example U.S. 6,203,464.

It is therefore desirable to have a speed sensor for a rotating shaft that does not require any projections, indentations, teeth, grooves or other physical manifestations or alterations and thus can be fabricated relatively fast and in a cost-effective manner.

### BRIEF SUMMARY OF THE INVENTION

It is a principle object of the present invention to provide a speed sensing devices for measuring the speed of a rotating shaft using a high resolution, cost effective and fast fabrication magnetic speed sensor.

It is another object of the present invention to provide a shaft that does not require a separate element which is affixed to the shaft, projects away from the surface of the shaft, or is in relief or sunken-relief relative to the surface of the shaft, for generating a dynamic magnetic flux.

It is still another object of the present invention to provide a fabrication method for a rotating shaft speed sensor by simply rotating a shaft and using strong magnetic signals from paired magnets which inject strong, local, gradient magnetic fields onto the shaft.

It is yet another object of the present invention to provide a fabrication method that is less expensive and requires less time to manufacture compared to prior art geared or teeth devices.

Still another object of the invention is to provide a method for making a speed sensor made from a shaft of generally homogeneous chemical composition throughout, having separate active and passive regions having magnetic properties appropriate for its respective function by endowing each such region with magnetic properties appropriate for its respective function.

Briefly described, the above and other objects and advantages of the present invention are accomplished, as embodied and fully described herein, by a method for forming a magnetic speed sensor for a rotatable shaft including the steps of forming a plurality of magnetic portions on the shaft, the magnetic portions capable of outputting a magnetic field detectable by at least one magnetic field sensor as the shaft rotates; and positioning the at least one magnetic field sensor near the shaft for outputting a signal corresponding to the angular speed of the shaft as the shaft rotates, wherein the magnetic portions are integrally formed in the shaft by magnetically polarizing the shaft material itself.

The method includes the step of providing the shaft, a portion of which is first endowed with a magnetic polarization directed substantially in a circumferential direction. The plurality of magnetic portions are approximately equally spaced apart magnetic portions that produce substantially the same or different external magnetic fields. The spaced apart magnetic portions are approximately equally spaced apart at pre-determined angles around the shaft, which may be 5, 10, 15, 30, 45, 60, 90 and 120 degrees apart. Each of the plurality of magnetic portions are formed using a magnetic pair that is positioned close to the shaft at each of the locations of the magnetic portions for a pre-determined time period.

The above and other objects and advantages of the present invention are also accomplished, as embodied and fully described herein, by a method for operating an angular speed sensor.

The objects and advantages of the present invention are further accomplished, as embodied and fully described herein, by an apparatus for determining the speed of a rotating shaft, the apparatus including plurality of magnetic portions on a shaft that output a magnetic field from each of the plurality of magnetic portions, wherein the plurality of magnetic portions are integrally formed in the shaft by magnetically polarizing the shaft material itself. The apparatus also includes at least one magnetic field sensor positioned proximate to the shaft for detecting the magnetic field from each of the plurality of magnetic portions and for outputting a signal corresponding to the angular speed of the shaft as the shaft rotates. The apparatus further includes a computation means for calculating the angular speed value of the shaft, and a display device for displaying the calculated speed value. The shaft may be part of a vehicle or other useful device.

### BRIEF DESCRIPTION OF THE SEVERAL DRAWINGS

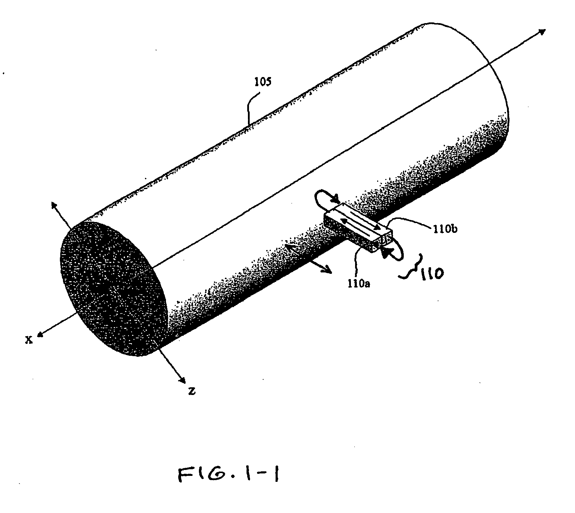

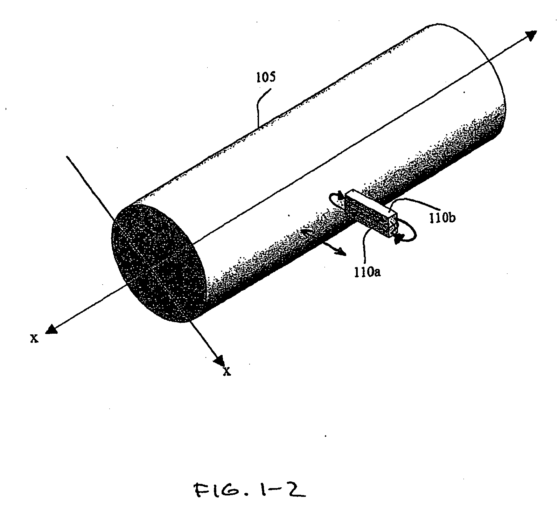

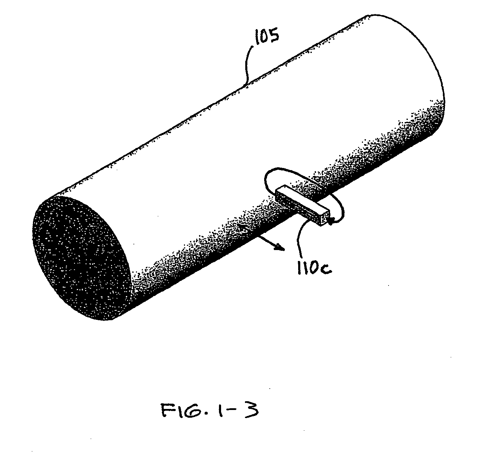

**FIG. 1-1** is a perspective view diagram of a rotatable shaft and a pair of permanent magnets according to one embodiment of the present invention;
**FIG**. **1-2** is a perspective view diagram of the rotatable shaft of **FIG. 1**-**1** with the pair of permanent magnets in a different orientation according to another embodiment of the present invention;
**FIG. 1-3** is a perspective view diagram of the rotatable shaft of **FIG. 1**-**1** with a single permanent magnet according to another embodiment of the present invention;
**FIG. 2** is a perspective view diagram of the rotatable shaft of **FIG. 1-1** after forming several magnetic portions in the shaft according to the present invention;
**FIG. 3** is a perspective view diagram of the axially-directed magnetic polarization induced in the individual magnetic portions according to the present invention;
**FIG. 4** is a perspective view diagram of the rotatable shaft of **FIG. 1-1** after forming several magnetic portions in the shaft according to the present invention;
**FIG. 5** is a graph showing the output from a magnetic field sensor according to the present invention; and
**FIG. 6** is a perspective view diagram of the rotatable shaft of **FIG. 1-1** showing a placement of magnetic field sensors according to the present invention.

### DETAILED DESCRIPTION OF THE INVENTION

Several preferred embodiments of the present invention are described for illustrative purposes, it being understood that the invention may be embodied in other forms not specifically shown in the drawings. The figures will be described with respect to the structure and functions that achieve one or more of the objects of the invention and/or receive the benefits derived from the advantages of the invention as understood by persons skilled in the art or explicitly set forth herein.

Turning first to **FIG. 1-1**, shown therein is a perspective view diagram of a rotatable shaft 105 and a pair of permanent magnets 110a, 110b (collectively 110) being mechanically held such that their end portions are equally in close proximity to the surface of the shaft 105. **FIG. 1-2** is the same perspective view but with the paired magnets 110a, 110b in a different orientation. **FIG. 1-3** is the same perspective view but with a single permanent magnet 110c being used.

As indicated by the double arrow, the paired magnets 110a, 110b and single magnet 110c may be moved toward and away from the shaft 105. In a first, or initial, position, the magnets are positioned about 127mm (5 inches) from the surface of the shaft 105 such that the magnetic fields from the magnets would not reach to the shaft 105. In the figures, the magnets 110a, 110b, 110c are shown in a second position. In the second position, the magnets have been advanced toward the surface of the shaft 105 and are held in place there. In that position, the magnets may be as close as 0.5 mm relative to the surface of the shaft 105, or they may actually touch the shaft 105. When moved toward the surface of the shaft 105, the magnets 110a, 110b, 110c move at a rate of about 25,4mm to 76,2mm (1 to 3 inches) per second. When moved away from the surface of the shaft 105, the magnets move at the same or a different rate.

The magnets 110a, 110b, 110c (collectively "110") may be NdBFe magnets that preferably have a magnetic strength of about 3342 MA/m (42 Moe) or higher.

The poles of the magnets 110 are such that the magnetic flux emanating from the north pole of the magnet 110a closest to the shaft 105 enters the south pole of the magnet 110b closest to the shaft 105. Likewise, to close the magnetic circuit, the flux emanating from the other end of the magnet 110b enters the other end of the magnet 110a. The same thing occurs in the case of a single magnet 110c, but the magnetic flux emanating from the north pole closest to the shaft 105 enters the south pole of the magnet 110c at the other end.

In this way, at least a portion of the shaft 105 is locally magnetically polarized due to it being in the path of the magnetic flux from the magnets 110. Any number of these magnetic spots 115 may be generated on and into the shaft 105 by the rotation of the shaft 105 relative to the magnets 110 (in their second position closest to the shaft) or by the repositioning of the magnets 110 relative to the surface of the shaft 105.

The general approach to magnetizing a shaft is taught in, for example, U.S. 5,351,555 and U.S. 5,520,059, which describe how the crystalline and magnetic nature of ferromagnetic materials are susceptible to being magnetized by a permanent magnet or an electro-magnet, thereby endowing the ferromagnetic material with a remanent magnetization. As noted in those disclosures, the shaft 105 does not have to be purely iron, as other materials may be included in the shaft 105, including alloy substances and substances that increase or decrease the ability of the material to hold a remanent magnetization.

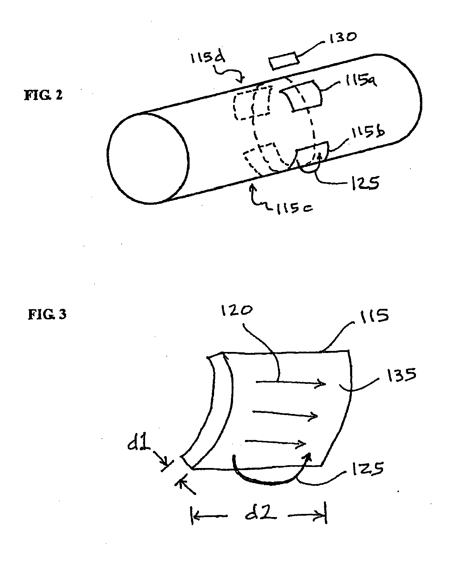

Turning to **FIG. 2**, shown therein is a perspective view diagram of the rotatable shaft 105 after forming several magnetic spots 115 in the shaft 105. To form evenly spaced apart magnetic spots 115, the shaft 105 is rotated (or, as noted above, the magnets 110 are rotated relative to the fixed shaft 105), by an angle of, for example, 90 degrees. The magnets 110 are then advanced from their initial position toward the shaft 105 to form a second magnetic spot 115, and then the magnets 110 are again withdrawn to their initial position. This procedure is repeated until the remaining magnetic spots 115 on the shaft 105 are formed, each using the same procedure described above. There is no wait time for the second magnetic spot to be created after the magnets 110 are withdrawn from the shaft 105. That is, the next magnetic spot 115 may be created right after the preceding spot has been created. In this way, about 1 or 2 minutes are all that are needed to create about six magnetic spots 115 on the shaft 105.

To further illustrate, in **FIG. 2** four magnetic spots 115a, 115b, 115c, and 115d around the shaft 105 have been created. Of course, instead of 90-degrees, if the shaft 105/magnets 110 are rotated 60 degrees relative to each other after forming the first magnetic spot 115a, then the shaft 105 would be endowed with six magnetic spots 115a, 115b, ..., 115f instead of just four magnetic spots. Likewise, if the shaft 105/magnets 110 are rotated 30 degree relative to each other after forming the first magnetic spot 115a, then the shaft 105 would be endowed with a total of 12 magnetic spot 115a, 115b, ..., 1151. Any angular separation could be used, including, but not limited to, 5, 10, 15, 30, 45, 60, 90 and 120 degrees. As more magnetic spots 115 are added and arranged circumferentially about the axis of the shaft 105, the aggregate magnetic spots 115 begin to approach a continuous band of magnetization. The preferred number of magnetic regions depends on the accuracy desired and the application in which the shaft 105 will be used. For some applications, 24 magnetic spots are necessary. But the maximum number of magnetic spots is dependent on the diameter of the shaft 105. With permanent magnets 110 having a square cross-section with 2 mm sides, and 1 mm separating the pair of magnets, about 5 mm of space is required for one magnetic spot. Therefore, a shaft 105 having a diameter of about 40 mm would be required to place 24 spots on the shaft.

The shaft 105 is initially prepared by remanently magnetizing it in a circumferential direction, as taught in, for example, U.S. 5,351,555 and U.S. 5,520,059. The material that is not circumferentially magnetized may become reactively magnetized from other magnetic sources, including the magnetic portions 115, and thus become a source of parasitic fields. The entire cross-section of the shaft 105 does not need to be circumferentially magnetized. This is because the torsional shear stress applied at the outer surface of the shaft 105 is reduced as the distance from the surface to the axis of the shaft 105 increases, and thus the relative potential contribution to the magnetic flux signal from the more central regions of the shaft 105 are minimal. Thus, it is only necessary to circumferentially magnetize the shaft 105 to a depth, in a small diameter shaft, of about 50-percent of the radius of the shaft 105.

Even if deeper regions of the shaft 105 were to develop field intensities at their location, the contribution from those deep location fields to the field intensity observed at the location where the external field sensor 130 is positioned, which is some distance radially outward from the surface of the shaft 105, would be substantially reduced and minimal. Thus, even in very large shafts, the circumferential magnetization deeper than 10-20 mm would provide little benefit. In many hollow shafts, penetrations to such depths would reach to the inside surface. This would be a desirable condition for hollow shafts, especially for thin wall hollow shafts, since they are made hollow in order to more efficiently use the available material strength and to reduce weight. If all of the shaft cross section is transmitting useful torque, it would make sense to have all of the cross section contribute to generating a detectable signal field rather than have some of it detract from the signal field and then contribute to the parasitic fields. As a practical matter, however, it is extremely difficult to magnetize to a depth greater than about 1-2 mm, even on large diameter shafts, because it is difficult to generate a strong enough magnetic field so far from the magnetic field source.

The same factors discussed above also reduce the capability of deeply interior, non-circumferentially magnetized regions to produce significantly troublesome parasitic fields at "distant" field sensors. Thus, while it is desirable to circumferentially magnetize the shaft 105 to a desirable depth, the fact that the rest of the shaft contains random local magnetizations, some of which may not be oriented circumferentially, is of no importance to the operation of the present invention for speed sensing purposes.

As shown in **FIG. 3**, the axially-directed magnetic polarization 120 induced in the individual magnetic portions 115 by the method described above is directed substantially in the axial direction (i.e., longitudinally or x-direction). This polarization 120 produces an axially-directed "leaking" magnetic field 125 above the surface 135 of the magnetic portion 115, which is also directed substantially in the axial direction of the shaft 105.

Magnetization in this way can place more localized magnetic spots 115 on the shaft 105 than using the single magnet 110c as shown in **FIG. 1-3**. In **FIG. 1-1**, the magnetic fields from the north pole of the magnet 110a goes into the south pole of the magnet 110b, which is attached to the magnet 110a. A single magnet like the magnet 110c can also create magnetic spots, but magnetic spot size becomes larger as magnetic flux lines diverge.

Another method of magnetization is placing the paired magnets as shown in **FIG. 1-2**. Magnetic flux lines created from this arrangement are circumferentially directed while the magnetic flux lines created from the arrangement in **FIG. 1-1** are directed in an axial direction. The magnetic flux "leakage" appears because the magnetic spots do not form a closed magnetic loop. These leakage fields can be detectable using a fluxgate sensor 130. Depending upon the arrangement of the paired magnets, the axial direction of the fluxgate sensor coils are differently placed above the shaft 105. For example, if the paired magnets 110a, 110b are arranged as shown in **FIG. 1-1**, then the axial direction of the fluxgate sensor coils should be parallel to the axis of the shaft 105, since the magnetic flux leakage fields are along the axial direction. If the paired magnets 110a, 110b are arranged as shown in **FIG. 1-2**, then the axial direction of the fluxgate sensors are along the circumferential direction, since the magnetic flux leakage fields are along the circumferential direction. If the shaft is also circumferentially magnetized for use as, for example, a torque sensor, it is preferred to magnetize the magnetic spots using the arrangement in **FIG. 102** as the fluxgate sensor placed parallel to the axial direction of shaft for speed sensor could also detect a torque-induced magnetic flux signal from the shaft 105.

This external flux may be detectable using, as noted above, a fluxgate sensor 130. The amount of the external field produced by each of the individual magnetic spots 115 should be approximately equal, but this is not required. The actual field strength is less important, because it is the time between peak signals that is important in terms of monitoring the speed of the shaft 105.

The dimensions of the magnetic spots 115 are defined first in the radial direction z, from the outer surface 135 of the shaft 105 to an annular depth *d1*, which depth is dependant on the strength of the magnets 110, as noted above. In the axial direction, the magnetic spot 115 is defined by the approximate width *d2*, which may be approximately the width of the permanent magnet pair 110, but could be wider or narrower. As noted above, this dimension could be about 5 mm, if two 2-mm wide magnets are used and spaced about 1 mm apart. Those of ordinary skill in the art will appreciate that the physical dimensions of the magnetic spot 115 could vary from one magnetic spot 115 to another on the same shaft 105, and they do not have to have the same curved polyhedron shape as depicted in the figure (which is for illustration purposes only). Indeed, the solid lines depicting the extent of the magnetic spots 115 in the shaft 105 in **FIG. 2** do not represent a distinct wall separating locally magnetized spots from the rest of the shaft 105. The magnetic spots 115 could have any shape. Precisely forming the magnetic spots 115 to exact dimensions is not important. What is important is that the magnetic spots form an external magnetic field that is detectable as the shaft 105 is rotated by the action of a torque or constant force being applied to the shaft 105.

Also, the shaft 105 does not have to have a uniform diameter along its axial direction, but could have a varying diameter along the length of the shaft 105. For example, the magnetized spots 115 could taper to a diameter that is less than the diameter of the rest of the shaft 105. The shaft 105 could also have a step increase or decrease in its diameter at an axially-extending portion relative to the rest of the shaft 105. As noted above, the shaft 105 may also be thin-walled (hollow).

Because the shaft 105 may undergo an applied torque in its rotating state (i.e., the drive axle of a vehicle during operation), the magnetized spots 115 must possess some source of anisotropy to return the magnetization to the established (during the polarization process) direction when the torque is reduced to zero, otherwise, the polarization may be degraded over time after repeated applications of torque. The degradation may be measured by the degree of the external magnetic field sensed by the field sensor 130. The anisotropy may be inherent in the nature of the crystalline material making up the shaft 105 (i.e., crystalline anisotropy), or may be imparted in the shaft 105 by any one of several physical treatment processes known in the art.

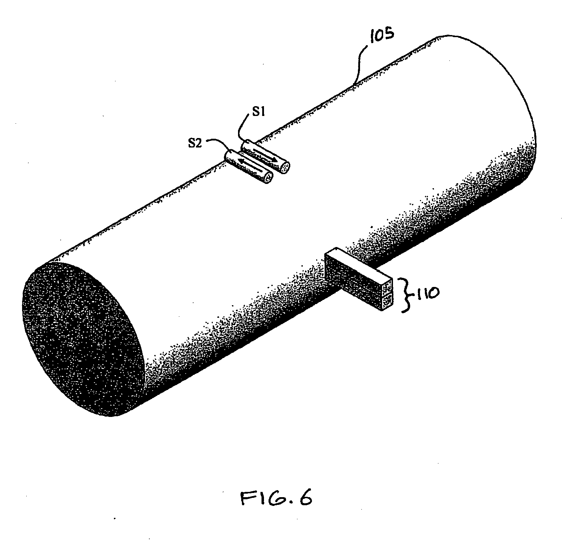

To ensure a symmetrical "spring back" response to both clockwise and counter-clockwise torques, or from other forces applied to an end of the shaft 105, the distribution of the local magnetizations should predominantly lie in the desired direction, though not all of the local magnetizations must be flipped in that direction during the aforementioned magnetization process. All that is required is that a sufficient number of the local magnetizations be in the desired direction in order for the leaking flux from those portions to sufficiently exceed (1) any parasitic fields arising from portions of the shaft 105 that are not magnetized in the manner described above, (2) any external fields from nearby field-generating sources (near sources); and (3) any background fields from distant sources. In order to cancel out such noise effects in (1), (2), and (3) above, an oppositely oriented fluxgate sensor coil S2 is placed just close (~5 mm) to the fluxgate sensor coil S1 which measures speed signal as shown in **FIG. 6**. S2 is positioned so that it is away from the magnetic spots 115, while S 1 is positioned so that it is near the magnetic spots 115. Therefore, S2 is just used for cancel out near field, compassing, and any other external noise signal.

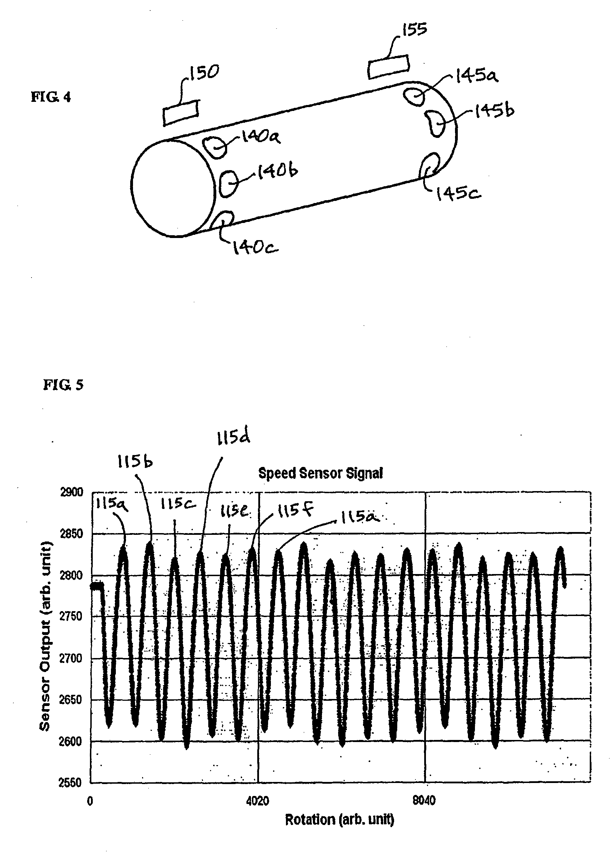

Turning now to **FIG. 4**, shown therein is a perspective view diagram of the rotatable shaft 105 after forming several magnetic portions in the shaft 105 in different axial locations. In this case, the magnetic spots are shown in two sets of magnetic spots designated 140a, 140b, ..., 140*n* in the first set, and 145a, 145b, ..., 145*n* in the second set, respectively. Each set of magnetic spots 140, 145 are separately monitored with a field sensor 150, 155, respectively. The number of sets of magnetic spots is determined by the application of the speed sensor. One set may be used as a backup set of magnetic spots to generate a backup or comparative signal. The two sets of magnetic spots may be located on different members of a two-member shaft that are interconnected to each other using gears (i.e., a gear box), where the speed of the two member is separately monitored. The two sets of magnetic spots could be on opposite ends of a very long shaft where, when one end may slightly move in advance of the other end, it is important to know the relative speeds of the ends of the shaft. Multiple sets of magnetic spots are necessary for a shaft with smaller diameter, since higher speed sensor resolution is required.

Turning now to **FIG. 5**, shown therein is a graph showing the output from a magnetic field sensor (i.e., S1, 130, 150, 155) according to the present invention as the shaft 105 is being rotated at a nearly constant angular speed relative to magnetic field sensor. The shaft used in this experiment included multiple magnetic spots formed using the method thus described. In particular, the shaft 105 was formed with six magnetic spots 115a, 115b, ..., 115f, each spaced apart from the other along a line oriented substantially circumferentially about the shaft 105, and positioned about 60 degree apart measured in the cross-sectional plane. After the magnetic spots 115 were magnetized in the manner described, the shaft 105 was rotated by the application of a constant force or torque applied to a known position on the shaft 105. Using a magnetic field sensor positioned near the magnetic spots 115 and oriented to detect the external magnetic field, the output from the field sensor was observed, which had the shape as shown in the graph. As shown in the graph, six peaks were detected during each rotation of the shaft 105 (i.e., six peaks were observed between 0 and 4020 units, six more peaks were observed between 4020 and 8040 units, six more peaks were observed in the next time period, etc.).

Thus, if the shaft 105 in the example above had a circumference, *C*, of 1 unit and the magnetic field sensor 130 detected six peaks corresponding to the six magnetic spots 115 during a time period, *T*, equal to 1 second, the average angular speed of the shaft at the end of the time period *T* would be *C*/*T* or 1 unit/sec. If twelve peaks were detected at the end of the second period, 2*T*, or 1.5 seconds (i.e., 1 second for the first rotation and 0.5 second for the second rotation), the average angular speed of the shaft at the end of the second time period would be calculated from 2*C*/2T or (2 units)/(1.5 sec) = 1.33 units/sec. Of course, instantaneous or near real-time calculations could be made after each peak is detected (the calculations would not be quasi real-time because of the slight delay in detecting the peak signal and processing the signal in the system control circuit (not shown). The above calculations may be done by a computational subsystem, which includes a printed circuit board having at least specific logic circuits, software, a memory device, and a power source. The calculated angular speed values may be stored in memory for later downloading to another device.

The specific calculations performed by the subsystem are described generally above. Expressed as an algorithm, they would include the steps of receiving from a user or embedded in a memory a value representing the circumference of the shaft and/or the angle between the magnetic spots; receiving the signal from the magnetic field sensor in the form of, for example, a voltage; processing the signal using conditioning circuits as needed; determining the time at which a peak signal was detected at the magnetic field sensor; determining the time at which a second peak signal was detected at the magnetic field sensor; adjusting the time values to account for environmental conditions, device-specific factors, lag time, or any other factor that would affect the calculations; calculating the interval of time between the peaks; retrieving the circumference and/or angle value between the plurality of magnetic spots for the shaft; calculating the angular speed; storing and/or outputting the calculated value; and repeating all or some of the above steps. The stored values may be overwritten by more recent calculated values such that only the most recent value is stored in the memory.

The graph in **FIG. 5** shows distinct and finely resolved peaks, suggesting that many more magnetic spots 115 could be used on the shaft 105 with small separation angles to increase the accuracy and resolution of the measured angular speed of the shaft 105.

The output signal from the magnetic field sensors S1, S2, 130, 150, and 155 according to the present invention could be in the form of an amount of voltage relative to ground. The signal may be processed using known signal conditioning circuits (not shown) to produce a signal useful, for example, displaying a real-time speed value on a display device indicating the actual or average angular speed of the shaft 105, or the speed of another object attached to the shaft 105 (e.g., a vehicle wheel, gear, steering column, drive shaft, auger shaft, propeller, etc.). The signal may also be used as an input to a speed regulating device (e.g., a braking system), or as input to a system monitoring device (e.g., as part of a computerized system for determining a maintenance schedule).

## Claims

1. A method for forming a magnetic speed sensor for a rotatable shaft (105) comprising the steps of:
forming at least one magnetic spot (115, 140, 145) on the shaft (105), the at least one magnetic spot (115, 140, 145) outputting a magnetic field (125) detectable by at least one magnetic field sensor (S1, 130, 150, 155) as the shaft (105) rotates; and
positioning the at least one magnetic field sensor (S 1, 130, 150, 155) near the shaft (105) for outputting a signal corresponding to the angular speed of the shaft (105) as the shaft (105) rotates, **characterized in that**,
the at least one magnetic spot (115, 140, 145) is integrally formed in the shaft by magnetically polarizing the shaft material itself,
wherein the shaft is formed of a generally homogeneous chemical composition, and wherein the at least one magnetic spot (115, 140, 145) is formed using a magnetic pair (110a, 110b) that is positioned close to the shaft (105) for a predetermined time period.

2. The method of claim 1, further comprising the step of
providing the shaft (105), a portion of which is first endowed with a magnetic polarization (120) directed substantially in a circumferential direction.

3. The method of claim 1, wherein a plurality of magnetic spots (115, 140, 145) comprise approximately equally spaced apart magnetic spots (115, 140, 145) producing substantially the same or different external magnetic fields (125).

4. The method of claim 3, wherein the spaced apart magnetic spots (115, 140, 145) are approximately equally spaced apart at pre-determined angles around the shaft (105).

5. The method of claim 4, wherein the pre-determined angles are selected from one of 5, 10, 15, 30, 45, 60, 90 and 120 degrees.

6. The method of claim 1, wherein a first one of a plurality of magnetic spots (115, 140, 145) is formed using a magnetic pair (110a, 110b) that is positioned close to the shaft (105) for a pre-determined time period.

7. The method of claim 1, wherein each of a plurality of magnetic spots (115, 140, 145) are formed using a magnetic pair (110a, 110b) that is positioned close to the shaft (105) at each of the locations of the magnetic spots (115, 140, 145) for a predetermined time period.

8. A method for operating an angular speed sensor comprising the steps of:
receiving an electronic signal from at least one magnetic field sensor (81, 130, 150, 155) corresponding to the angular speed of a shaft (105) as the shaft (105) rotates, wherein the magnetic field sensor (81,130,150,155) is fixed relative to the shaft (105) and positioned close to the shaft (105) for detecting a magnetic field (125) each emanating from one of a corresponding at least one magnetic spot (115, 140, 145) on the shaft (105) as each of the at least one of magnetic spots (115, 140, 145) is moved proximate to the magnetic field sensor (81, 130, 150, 155);
calculating using the signal an angular speed value for the shaft (105); and
storing at least temporarily the calculated angular speed value,
**characterized in that** the at least one magnetic spot (115, 140, 145) is integrally formed in the shaft (105) by magnetically polarizing the shaft material itself,
wherein the shaft is formed of a generally homogeneous chemical composition.

9. The method of claim 8, further comprising the step of outputting the calculated angular speed value to a display device.

10. The method of claim 8, further comprising the step of mechanically adjusting the angular speed of the shaft (105) to a different angular speed.

11. The method of claim 8, further comprising the step of endowing the shaft (105) with the plurality of magnetic spots (115, 140, 145).

12. The method of claim 8, wherein a plurality of magnetic spots (115, 140, 145) comprise approximately equally spaced apart magnetic spots (115, 140, 145) producing substantially the same or different external magnetic fields (125).

13. The method of claim 12, wherein the spaced apart magnetic spots (115, 140, 145) are approximately equally spaced apart at pre-determined angles around the shaft (105).

14. The method of claim 1, wherein each of the at least one magnetic spots (115, 140, 145) is formed using a magnetic pair (110a, 110b) that is positioned close to the shaft (105) at each of the locations of the magnetic spots (115, 140, 145) for a predetermined time period.

15. An apparatus for determining the speed of a rotating shaft (105) comprising:
at least one magnetic spot (115, 140, 145) on a shaft (105) for outputting a magnetic field (125) from each of the at least one magnetic spots (115, 140, 145), **characterized in that** the at least one magnetic spot (115, 140, 145) is integrally formed in the shaft (105) by magnetically polarizing the shaft material itself; and
at least one magnetic field sensor (81, 130, 150, 155) positioned proximate to the shaft (105) for detecting the magnetic field (125) from each of the at least one magnetic spot (115, 140, 145) and for outputting a signal corresponding to the angular speed of the shaft (105) as the shaft (105) rotates,
wherein the shaft is formed of a generally homogeneous chemical composition.

16. The apparatus of claim 15, wherein a portion of the shaft (105) is endowed with a magnetic polarization (120) directed substantially in a circumferential direction.

17. The apparatus of claim 15, wherein a plurality of magnetic spots (115, 140, 145) comprise are substantially equally spaced apart.

18. The apparatus of claim 17, wherein the substantially equally spaced apart magnetic spots (115, 140, 145) are approximately equally spaced apart at predetermined angles around the shaft (105).

19. The apparatus of claim 18, wherein the pre-determined angles are selected from one of 5, 10, 15, 30, 45, 60, 90 and 120 degrees.

20. The apparatus of claim 15, wherein a first one of the at least one magnetic spots (115, 140, 145) is formed using a magnetic pair (110a, 110b) that is positioned close to the shaft (105) for a pre-determined time period.

21. The apparatus of claim 15, wherein each of a plurality of magnetic spots (115, 140, 145) is formed using a magnetic pair (110a, 110b) that is positioned close to the shaft (105) at each of the locations of the magnetic spots (115, 140, 145) for a predetermined time period.

22. The apparatus of claim 15, further comprising computation means for calculating the angular speed value of the shaft (105).

23. The apparatus of claim 22, further comprising a display device for displaying the calculated speed value.

24. The apparatus of claim 15, wherein the shaft (105) is part of a vehicle.

## Patentansprüche

1. Verfahren zur Bildung eines magnetischen Drehzahlsensors für eine drehbare Welle (105), das die folgenden Schritte umfasst:
Bilden wenigstens eines Magnetflecks (115, 140, 145) auf der Welle (105), wobei der wenigstens eine Magnetfleck (115, 140, 145) ein Magnetfeld (125) abgibt, das von wenigstens einem Magnetfeldsensor (S1, 130, 150, 155) erfasst werden kann, während sich die Welle (105) dreht, und
Positionieren des wenigstens einen Magnetfeldsensors (S 1, 130, 150, 155) in der Nähe der Welle (105) zur Abgabe eines Signals, das der Winkelgeschwindigkeit der Welle (105) entspricht, während sich die Welle (105) dreht, **dadurch gekennzeichnet, dass**
der wenigstens eine Magnetfleck (115, 140, 145) einstückig in der Welle gebildet wird, indem das Wellenmaterial selbst magnetisch polarisiert wird,
wobei die Welle aus einer insgesamt homogenen chemischen Zusammensetzung gebildet wird und wobei der wenigstens eine Magnetfleck (115, 140, 145) unter Verwendung eines Magnetpaars (110a, 110b) gebildet wird, das einen vorbestimmten Zeitraum lang nahe der Welle (105) positioniert wird.

2. Verfahren nach Anspruch 1, ferner mit dem Schritt, bei dem
die Welle (105) bereitgestellt wird, wobei ein Abschnitt der Welle zuerst mit einer magnetischen Polarisation (120) ausgestattet wird, die im Wesentlichen in einer Umfangsrichtung gerichtet ist.

3. Verfahren nach Anspruch 1, bei dem mehrere Magnetflecken (115, 140, 145) annähernd gleich weit voneinander beabstandete Magnetflecken (115, 140, 145) umfassen, die im Wesentlichen die gleichen oder unterschiedliche äußere Magnetfelder (125) erzeugen.

4. Verfahren nach Anspruch 3, bei dem die voneinander beabstandeten Magnetflecken (115, 140, 145) in vorbestimmten Winkeln um die Welle (105) annähernd gleich weit voneinander beabstandet sind.

5. Verfahren nach Anspruch 4, bei dem die vorbestimmten Winkel aus einem Wert von 5, 10, 15, 30, 45, 60, 90 oder 120 Grad gewählt werden.

6. Verfahren nach Anspruch 1, bei dem ein erster von mehreren Magnetflecken (115, 140, 145) unter Verwendung eines Magnetpaars (110a, 110b) gebildet wird, das einen vorbestimmten Zeitraum lang nahe der Welle (105) positioniert wird.

7. Verfahren nach Anspruch 1, bei dem mehrere Magnetflecken (115, 140, 145) jeweils unter Verwendung eines Magnetpaars (110a, 110b) gebildet werden, das einen vorbestimmten Zeitraum lang nahe der Welle (105) an jeder der Stellen der Magnetflecken (115, 140, 145) positioniert wird.

8. Verfahren zum Betreiben eines Winkelgeschwindigkeitssensors, das die folgenden Schritte umfasst:
Empfangen eines elektronischen Signals von wenigstens einem Magnetfeldsensor (81, 130, 150, 155), das der Winkelgeschwindigkeit einer Welle (105) entspricht, während sich die Welle (105) dreht, wobei der Magnetfeldsensor (81, 130, 150, 155) relativ zur Welle (105) befestigt und nahe der Welle (105) positioniert wird, um ein Magnetfeld (125) zu erfassen, das jeweils von einem entsprechenden wenigstens einen Magnetfleck (115, 140, 145) auf der Welle (105) ausgeht, wenn der wenigstens eine der Magnetflecken (115, 140, 145) jeweils in die Nähe des Magnetfeldsensors (81, 130, 150, 155) bewegt wird,
Berechnen eines Winkelgeschwindigkeitswertes für die Welle (105) unter Verwendung des Signals und
Speichern des errechneten Winkelgeschwindigkeitswertes zumindest vorübergehend,
**dadurch gekennzeichnet, dass** der wenigstens eine Magnetfleck (115, 140, 145) einstückig in der Welle (105) gebildet wird, indem das Wellenmaterial selbst magnetisch polarisiert wird,
wobei die Welle aus einer insgesamt homogenen chemischen Zusammensetzung gebildet wird.

9. Verfahren nach Anspruch 8, ferner mit dem Schritt, bei dem der errechnete Winkelgeschwindigkeitswert an ein Anzeigegerät ausgegeben wird.

10. Verfahren nach Anspruch 8, ferner mit dem Schritt, bei dem die Winkelgeschwindigkeit der Welle (105) mechanisch auf eine andere Winkelgeschwindigkeit eingestellt wird.

11. Verfahren nach Anspruch 8, ferner mit dem Schritt, bei dem die Welle (105) mit den mehreren Magnetflecken (115, 140, 145) ausgestattet wird.

12. Verfahren nach Anspruch 8, bei dem mehrere Magnetflecken (115, 140, 145) annähernd gleich weit voneinander beabstandete Magnetflecken (115, 140, 145) umfassen, die im Wesentlichen die gleichen oder unterschiedliche äußere Magnetfelder (125) erzeugen.

13. Verfahren nach Anspruch 12, bei dem die voneinander beabstandeten Magnetflecken (115, 140, 145) in vorbestimmten Winkeln um die Welle (105) annähernd gleich weit voneinander beabstandet sind.

14. Verfahren nach Anspruch 1, bei dem der wenigstens eine Magnetfleck (115, 140, 145) jeweils unter Verwendung eines Magnetpaars (110a, 110b) gebildet wird, das einen vorbestimmten Zeitraum lang nahe der Welle (105) an jeder der Stellen der Magnetflecken (115, 140, 145) positioniert wird.

15. Vorrichtung zur Bestimmung der Drehzahl einer sich drehenden Welle (105), mit:
wenigstens einem Magnetfleck (115, 140, 145) auf einer Welle (105) zum Abgeben eines jeweiligen Magnetfelds (125) von dem wenigstens einen Magnetfleck (115, 140, 145), **dadurch gekennzeichnet, dass** der wenigstens eine Magnetfleck (115, 140, 145) einstückig in der Welle (105) gebildet ist, indem das Wellenmaterial selbst magnetisch polarisiert ist, und
wenigstens einem Magnetfeldsensor (81, 130, 150, 155), der in der Nähe der Welle (105) positioniert ist, um das Magnetfeld (125) jeweils von dem wenigstens einen Magnetfleck (115, 140, 145) zu erfassen und ein Signal abzugeben, das der Winkelgeschwindigkeit der Welle (105) entspricht, während sich die Welle (105) dreht,
wobei die Welle aus einer insgesamt homogenen chemischen Zusammensetzung gebildet ist.

16. Vorrichtung nach Anspruch 15, bei der ein Abschnitt der Welle (105) mit einer magnetischen Polarisation (120) ausgestattet ist, die im Wesentlichen in einer Umfangsrichtung gerichtet ist.

17. Vorrichtung nach Anspruch 15, bei der mehrere Magnetflecken (115, 140, 145) im Wesentlichen gleich weit voneinander beabstandet sind.

18. Vorrichtung nach Anspruch 17, bei der die im Wesentlichen gleich weit voneinander beabstandeten Magnetflecken (115, 140, 145) in vorbestimmten Winkeln um die Welle (105) annähernd gleich weit voneinander beabstandet sind.

19. Vorrichtung nach Anspruch 18, bei der die vorbestimmten Winkel aus einem Wert von 5, 10, 15, 30, 45, 60, 90 oder 120 Grad gewählt sind.

20. Vorrichtung nach Anspruch 15, bei der ein erster von dem einen oder den mehreren Magnetflecken (115, 140, 145) unter Verwendung eines Magnetpaars (110a, 110b) gebildet ist, das einen vorbestimmten Zeitraum lang nahe der Welle (105) positioniert ist.

21. Vorrichtung nach Anspruch 15, bei der jeder von mehreren Magnetflecken (115, 140, 145) unter Verwendung eines Magnetpaars (110a, 110b) gebildet ist, das einen vorbestimmten Zeitraum lang nahe der Welle (105) an jeder der Stellen der Magnetflecken (115, 140, 145) positioniert ist.

22. Vorrichtung nach Anspruch 15, ferner mit Berechnungsmitteln zur Errechnung des Winkelgeschwindigkeitswertes der Welle (105).

23. Vorrichtung nach Anspruch 22, ferner mit einem Anzeigegerät zum Anzeigen des errechneten Geschwindigkeitswertes.

24. Vorrichtung nach Anspruch 15, bei der die Welle (105) Teil eines Fahrzeugs ist.

## Revendications

1. Procédé de réalisation d'un capteur de vitesse de rotation magnétique pour un arbre rotatif (105), comprenant les étapes suivantes :
réalisation d'au moins une zone magnétique (115, 140, 145) sur l'arbre (105), ladite au moins une zone magnétique (115, 140, 145) produisant un champ magnétique (125) apte à être détecté par au moins un capteur de champ magnétique (S1, 130, 150, 155) lorsque l'arbre (105) tourne ; et
agencement dudit au moins un capteur de champ magnétique (S1, 130, 150, 155) près de l'arbre (105) pour émettre un signal correspondant à la vitesse angulaire de l'arbre (105) lorsque l'arbre (105) tourne, **caractérisé en ce que**
ladite au moins une zone magnétique (115, 140, 145) est réalisée d'un seul tenant dans l'arbre en polarisant magnétiquement la matière de l'arbre elle-même,
l'arbre étant réalisé à partir d'une composition chimique généralement homogène, et ladite au moins une zone magnétique (115, 140, 145) étant réalisée en utilisant une paire magnétique (110a, 110b) agencée près de l'arbre (105) pour une période de temps prédéterminée.

2. Procédé selon la revendication 1, comprenant en outre l'étape suivante :
prévision de l'arbre (105) dont un tronçon est tout d'abord pourvu d'une polarisation magnétique (120) dirigée sensiblement dans une direction circonférentielle.

3. Procédé selon la revendication 1, dans lequel une pluralité de zones magnétiques (115, 140, 145) comprend des zones magnétiques (115, 140, 145) agencées à distances approximativement égales qui produisent sensiblement les mêmes ou différents champs magnétiques externes (125).

4. Procédé selon la revendication 3, dans lequel les zones magnétiques (115, 140, 145) espacées sont agencées à distances approximativement égales sous des angles prédéterminés autour de l'arbre (105).

5. Procédé selon la revendication 4, dans lequel les angles prédéterminés sont choisis parmi 5, 10, 15, 30, 45, 60, 90 et 120 degrés.

6. Procédé selon la revendication 1, dans lequel une première zone magnétique parmi une pluralité de zones magnétiques (115, 140, 145) est réalisée en utilisant une paire magnétique (110a, 110b) agencée près de l'arbre (105) pour une période de temps prédéterminée.

7. Procédé selon la revendication 1, dans lequel chaque zone magnétique parmi une pluralité de zones magnétiques (115, 140, 145) est réalisée en utilisant une paire magnétique (110a, 110b) agencée près de l'arbre (105) à chaque emplacement des zones magnétiques (115, 140, 145) pour une période de temps prédéterminée.

8. Procédé de mise en oeuvre d'un capteur de vitesse angulaire, comprenant les étapes suivantes :
réception d'un signal électronique d'au moins un capteur de champ magnétique (81, 130, 150, 155) correspondant à la vitesse angulaire d'un arbre (105) lorsque l'arbre (105) tourne, le capteur de champ magnétique (81, 130, 150, 155) étant fixe par rapport à l'arbre (105) et étant agencé près de l'arbre (105) pour détecter un champ magnétique (125) provenant respectivement d'une zone magnétique parmi au moins une zone magnétique (115, 140, 145) correspondante sur l'arbre (105) lorsque chacune desdites au moins une zone magnétique (115, 140, 145) est déplacée à proximité du capteur de champ magnétique (81, 130, 150, 155) ;
calcul d'une valeur de vitesse angulaire pour l'arbre (105) en utilisant le signal ; et
mémorisation au moins temporairement de la valeur de vitesse angulaire calculée,
**caractérisé en ce que** ladite au moins une zone magnétique (115, 140, 145) est réalisée d'un seul tenant dans l'arbre (105) en polarisant magnétiquement la matière de l'arbre elle-même,
l'arbre étant réalisé à partir d'une composition chimique généralement homogène.

9. Procédé selon la revendication 8, comprenant en outre l'étape dans laquelle la valeur de vitesse angulaire calculée est fournie à un appareil d'affichage.

10. Procédé selon la revendication 8, comprenant en outre l'étape dans laquelle la vitesse angulaire de l'arbre (105) est adaptée de manière mécanique à une vitesse angulaire différente.

11. Procédé selon la revendication 8, comprenant en outre l'étape dans laquelle l'arbre (105) est pourvu de la pluralité de zones magnétiques (115, 140, 145).

12. Procédé selon la revendication 8, dans lequel une pluralité de zones magnétiques (115, 140, 145) comprend des zones magnétiques (115, 140, 145) agencées à distances approximativement égales qui produisent sensiblement les mêmes ou différents champs magnétiques externes (125).

13. Procédé selon la revendication 12, dans lequel les zones magnétiques (115, 140, 145) espacées sont agencées à distances approximativement égales sous des angles prédéterminés autour de l'arbre (105).

14. Procédé selon la revendication 1, dans lequel chacune desdites au moins une zones magnétiques (115, 140, 145) est réalisée en utilisant une paire magnétique (110a, 110b) agencée près de l'arbre (105) à chaque emplacement des zones magnétiques (115, 140, 145) pour une période de temps prédéterminée.

15. Dispositif de détermination de la vitesse de rotation d'un arbre rotatif (105), présentant :
au moins une zone magnétique (115, 140, 145) sur un arbre (105) pour émettre un champ magnétique (125) depuis chacune desdites au moins une zones magnétiques (115, 140, 145), **caractérisé en ce que** ladite au moins une zone magnétique (115, 140, 145) est réalisée d'un seul tenant dans l'arbre (105) en polarisant magnétiquement la matière de l'arbre elle-même ; et
au moins un capteur de champ magnétique (81, 130, 150, 155) agencé à proximité de l'arbre (105) pour détecter le champ magnétique (125) de chacune desdites au moins une zones magnétiques (115, 140, 145) et pour fournir un signal correspondant à la vitesse angulaire de l'arbre (105) lorsque l'arbre (105) tourne,
l'arbre étant réalisé à partir d'une composition chimique généralement homogène.

16. Dispositif selon la revendication 15, dans lequel un tronçon de l'arbre (105) est pourvu d'une polarisation magnétique (120) dirigée sensiblement dans une direction circonférentielle.

17. Dispositif selon la revendication 15, dans lequel une pluralité de zones magnétiques (115, 140, 145) sont agencées à distances sensiblement égales.

18. Dispositif selon la revendication 17, dans lequel les zones magnétiques (115, 140, 145) agencées à distances sensiblement égales sont espacées à distances approximativement égales sous des angles prédéterminés autour de l'arbre (105).

19. Dispositif selon la revendication 18, dans lequel les angles prédéterminés sont choisis parmi 5, 10, 15, 30, 45, 60, 90 et 120 degrés.

20. Dispositif selon la revendication 15, dans lequel une première zone magnétique parmi lesdites au moins une zones magnétiques (115, 140, 145) est réalisée en utilisant une paire magnétique (110a, 110b) qui est agencée près de l'arbre (105) pour une période de temps prédéterminée.

21. Dispositif selon la revendication 15, dans lequel chaque zone magnétique parmi une pluralité de zones magnétiques (115, 140, 145) est réalisée en utilisant une paire magnétique (110a, 110b) agencée près de l'arbre (105) à chaque emplacement des zones magnétiques (115, 140, 145) pour une période de temps prédéterminée.

22. Dispositif selon la revendication 15, comprenant en outre des moyens de calcul pour calculer la valeur de vitesse angulaire de l'arbre (105).

23. Dispositif selon la revendication 22, comprenant en outre un appareil d'affichage pour afficher la valeur de vitesse calculée.

24. Dispositif selon la revendication 15, dans lequel l'arbre (105) fait partie d'un véhicule.
